# EUROPEAN PATENT SPECIFICATION

(11) **EP 4 513 514 B1**
(45) Date of publication and mention of the grant of the patent: **29.07.2026**
(21) Application number: 24770720.1
(22) Date of filing: 07.03.2024
(51) Int. Cl.: H10N 60/01, H10N 60/20, H10N 60/85, H01B 12/06

(54) **SUPERCONDUCTING WIRE MATERIAL AND PRODUCTION METHOD FOR SUPERCONDUCTING WIRE MATERIAL**
SUPRALEITENDES DRAHTMATERIAL UND HERSTELLUNGSVERFAHREN FÜR SUPRALEITENDES DRAHTMATERIAL
MATÉRIAU DE FIL SUPRACONDUCTEUR ET PROCÉDÉ DE PRODUCTION DE MATÉRIAU DE FIL SUPRACONDUCTEUR

(30) Priority: 15.03.2023 JP 2023040888
(43) Date of publication of application: 26.02.2025
(73) Proprietor: SUMITOMO ELECTRIC INDUSTRIES, LTD., Osaka-shi, Osaka 541-0041 (JP)
(72) Inventor: INAGAKI, Makoto, Osaka-shi, Osaka 541-0041 (JP); HONDA, Genki, Osaka-shi, Osaka 541-0041 (JP)
(74) Representative: Grünecker Patent- und Rechtsanwälte PartG mbB
(86) International application number: PCT/JP2024/008820
(87) International publication number: WO 2024/190614

(56) References cited:
- JP-A- 2013 122 847
- JP-A- 2014 207 056
- JP-A- 2014 207 056
- JP-A- H06 199 520

## Description

### TECHNICAL FIELD

The present invention relates to a superconductive wire and a method of manufacturing a superconductive wire. The present application claims the benefit of priority to Japanese Patent Application No. 2023-040888 filed on March 15, 2023.

### BACKGROUND ART

Japanese Patent Laying-Open No. 2015-106521 (PTL 1) describes a superconductive wire. The superconductive wire described in PTL 1 includes a metal substrate, a buffer layer disposed on the metal substrate, and an oxide superconductive film disposed on the buffer layer. A constituent material of the oxide superconductive film is REBa₂Cu₃Oₓ (RE represents a rare earth element). The oxide superconductive film contains crystals oriented in the c-axis direction of REBa₂Cu₃Oₓ.

### CITATION LIST

### PATENT LITERATURE

PTL 1: Japanese Patent Laying-Open No. 2015-106521
JP H06-199520 A discloses a method for producing a metal oxide in which part of the oxygen (D) in a metal oxide of the general formula *AxByCzDn* is replaced by a halogen element. In this formula, A denotes a rare-earth element, yttrium, a rare-earth metal, or an element obtained by partially substituting yttrium with an alkali or alkaline-earth metal; B is an alkaline-earth metal; C is copper or a transition-metal substituent; and D is oxygen. For X = 1, Y = 2-4, Z = 2.7-6, and n = 6-13. The synthesis includes (a) preparing the metal oxide of the general formula; (b) subjecting the oxide to a reduction treatment; and (c) halogenating the reduced oxide.
JP 2014-207056 A relates to a method for manufacturing an oxide-superconductive wire. The method includes preparing a raw-ingredient solution by adding chlorine to a fluorine-free organic metal compound solution; forming a first roasted film on an oriented metal substrate by coating and roasting this solution; forming a thicker second roasted film on the first film by coating and roasting a further raw-ingredient solution; and forming oxide-superconductive layers by crystallizing both roasted films through a main firing heat treatment.

### SUMMARY OF INVENTION

The superconductive wire of the present invention includes a superconductive layer containing REBa₂Cu₃Oₓ (RE represents a rare earth element). The superconductive layer contains halogen. The concentration of halogen in the superconductive layer is less than 2000 ppm by mass.

### BRIEF DESCRIPTION OF DRAWINGS

Fig. 1 is a cross-sectional view of a superconductive wire 100;
Fig. 2 is a flow chart illustrating a method of manufacturing superconductive wire 100;
Fig. 3 is a cross-sectional view illustrating a preparation step S1;
Fig. 4 is a cross-sectional view illustrating a buffer layer formation step S2;
Fig. 5 is a cross-sectional view illustrating a solution application step S3;
Fig. 6 is a cross-sectional view illustrating a first calcination step S4; and
Fig. 7 is a cross-sectional view illustrating a second calcination step S5.

### DETAILED DESCRIPTION

### [Problem to be Solved by the Present Invention]

In the superconductive wire described in PTL 1, the oxide superconductive film is formed by the following method. Firstly, a raw material solution is prepared. The raw material solution contains chlorine and constituent elements of the oxide superconductive film. Secondly, the raw material solution is applied onto the buffer layer. Thirdly, a first calcination is performed. As a result, Ba₂Cu₃O₄Cl₄ is deposited on the surface of the buffer layer. Fourthly, a second calcination is performed. As a result, REBa₂Cu₃Oₓ crystals are formed on the buffer layer and grown while being oriented in a specific crystal orientation, thereby forming the oxide superconductive film. Ba₂Cu₃O₄Cl₄ assists in orienting the REBa₂Cu₃Oₓ crystals.

In the superconductive wire described in PTL 1, chlorine is contained in the raw material solution, chlorine is also contained in the oxide superconductive film. Chlorine contained in the oxide superconductive film may disrupt the compositional balance of REBa₂Cu₃Oₓ or reduce the volume of the oxide superconductive film.

The present invention has been made in view of the above-mentioned problem in the prior arts. An object of the present invention is to provide a superconductive wire with a reduced concentration of halogen in a superconductive layer.

### [Advantageous Effect of the Present Disclosure]

According to the present invention, a superconductive wire with a reduced concentration of halogen in a superconductive layer can be provided according to claim 1 and the method according to claim 7.

### [Details of Embodiments of the Present Invention]

Next, an embodiment of the present invention will be described in detail with reference to the drawings. In the following drawings, the same or corresponding parts are denoted by the same reference numerals, and the description thereof will not be repeated. The superconductive wire according to the embodiment will be denoted as a superconductive wire 100.

### (Superconductive Wire 100)

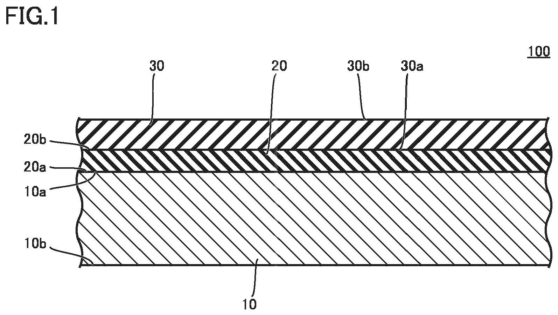

The configuration of the superconductive wire 100 will be described below with reference to Fig. 1.

As illustrated in Fig. 1, the superconductive wire 100 includes a substrate 10, a buffer layer 20, and a superconductive layer 30. The superconductive wire 100 may further include a protective layer and a stabilizing layer. In this case, the constituent material of the protective layer is, for example, silver or a silver alloy, and the constituent material of the stabilizing layer is, for example, copper or a copper alloy. The protective layer is disposed on the superconductive layer 30. The stabilizing layer is disposed on the protective layer.

The substrate 10 has a main surface 10a and a main surface 10b. The main surface 10a and the main surface 10b are end surfaces in the thickness direction of the substrate 10. The main surface 10b is opposite to the main surface 10a.

The substrate 10 is, for example, a clad material that includes a tape member made of stainless steel, a copper (Cu) layer disposed on the tape member, and a nickel (Ni) layer disposed on the copper layer. The crystal axis of the copper layer is oriented. The crystal axis of the nickel layer is also oriented along the crystal axis of the copper layer. The nickel layer constitutes the main surface 10a. The substrate 10 is not limited to the clad material described above, and may be a material other than the clad material. The substrate 10 may be made of, for example, Hastelloy (registered trademark). The substrate 10 may be a tape member made of a biaxially oriented metal material or a tape member made of a non-oriented metal material.

The buffer layer 20 has a main surface 20a and a main surface 20b. The main surface 20a and the main surface 20b are end surfaces in the thickness direction of the buffer layer 20. The buffer layer 20 is disposed on the substrate 10 in such a manner that the main surface 20a is opposite to the main surface 10a (the main surface 20a faces the main surface 10a).

The buffer layer 20 includes, for example, an yttria (Y₂O₃) layer, an yttria-stabilized zirconia (YSZ) layer disposed on the yttria layer, and a cerium oxide (CeO₂) layer disposed on the yttria-stabilized zirconia layer. The structure of the buffer layer 20 is not limited thereto. Since the crystal axis of the nickel layer of the substrate 10 is oriented as described above, the crystal axis of each layer in the buffer layer 20 is also oriented. The buffer layer 20 may have a two-layer structure or a single-layer structure.

The superconductive layer 30 is disposed on the buffer layer 20 (the main surface 20b). Since the crystal axis of the buffer layer 20 is oriented as described above, the c-axis, i.e., the crystal axis of the superconductive layer 30 is also oriented along the crystal axis of the buffer layer 20. Typically, the superconductive layer 30 is oriented such that the c-axis of the crystals of the constituent material (REBa₂Cu₃Oₓ to be described later) is oriented along the normal direction of the main surface 20b. In the present embodiment, "the c-axis is oriented along the normal direction of the main surface 20b" means that an inclination angle of the c-axis with respect to the normal direction of the main surface 20b is equal to or less than 15°. The superconductive layer 30 has a main surface 30a and a main surface 30b. The main surface 30a and the main surface 30b are end surfaces in the thickness direction of the superconductive layer 30. The main surface 30a faces the buffer layer 20 (the main surface 20b). The main surface 30b is opposite to the main surface 30a.

The constituent material of the superconductive layer 30 is REBa₂Cu₃Oₓ. In the present embodiment, RE represents a rare earth element. The rare earth element is, for example, gadolinium (Gd), yttrium (Y), or eurobium (Eu). However, the rare earth element is not limited thereto. The superconductive layer 30 contains halogen. The halogen is, for example, chlorine (Cl). However, halogen is not limited thereto. The superconductive layer 30 contains an alkali metal.
The alkali metal is, for example, sodium (Na). However, the alkali metal is not limited thereto. The superconductive layer 30 may not contain an alkali metal.

The concentration of halogen in the superconductive layer 30 is less than 2000 ppm by mass. The concentration of halogen in the superconductive layer 30 may be 1800 ppm or less by mass or 1500 ppm or less by mass. The concentration of halogen in the superconductive layer 30 is, for example, 2 ppm or more by mass. The concentration of the alkali metal in the superconductive layer 30 is, for example, 2000 ppm or less by mass. The concentration of the alkali metal in the superconductive layer 30 is, for example, 1 ppb or more by mass. The concentration of halogen in the superconductive layer 30 and the concentration of alkali metal in the superconductive layer 30 are measured by ICP (Inductively Coupled Plasma) analysis, in other words, a method of dissolving the superconductive layer 30 in a solution and analyzing the concentration of ions in the solution. The concentration of halogen (or the alkali metal) in the superconductive layer 30 is the mass ratio of halogen (or the alkali metal) to the total mass of all elements contained in the superconductive layer 30. In other words, the total mass of all the elements constituting the superconductive layer 30 is 100 percent.

Ba₂Cu₃O₄X₂ may precipitate on the interface between the superconductive layer 30 and the main surface 20b, in the superconductive layer 30, and on the main surface 30b. X represents halogen. The amount of Ba₂Cu₃O₄X₂ precipitated on the main surface 30b may be greater than the amount of Ba₂Cu₃O₄X₂ precipitated in the superconductive layer 30.

### (Method of Manufacturing Superconductive Wire 100)

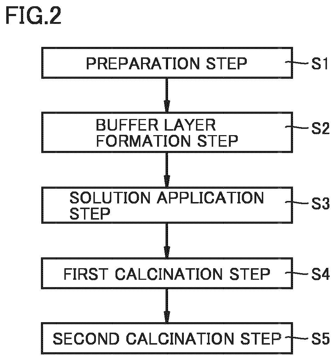

Hereinafter, a method of manufacturing the superconductive wire 100 will be described with reference to Figs. 2 to 7.

As illustrated in Fig. 2, the method of manufacturing the superconductive wire 100 includes a preparation step S1, a buffer layer formation step S2, a solution application step S3, a first calcination step S4, and a second calcination step S5. The buffer layer formation step S2 is performed after the preparation step S1. The solution application step S3 is performed after the buffer layer formation step S2. The first calcination step S4 is performed after the solution application step S3. The second calcination step S5 is performed after the first calcination step S4.

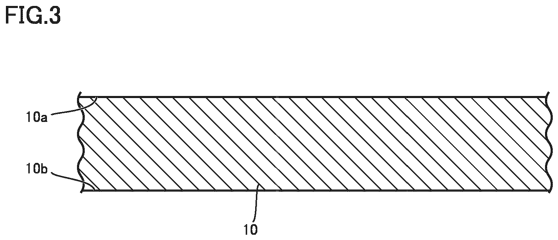

As illustrated in Fig. 3, in the preparation step S1, the substrate 10 is prepared. The buffer layer 20 is not disposed on the substrate 10 prepared in the preparation step S1.

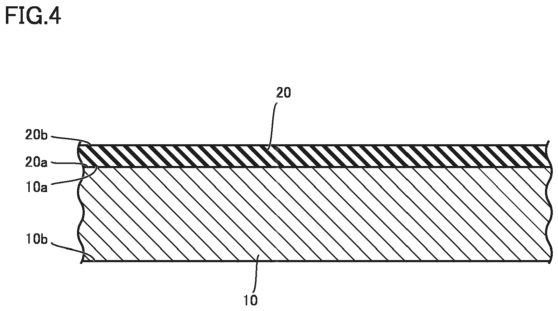

As illustrated in Fig. 4, in the buffer layer formation step S2, the buffer layer 20 is formed on the substrate 10. The buffer layer 20 is formed by sequentially forming the layers constituting the buffer layer 20 by magnetron sputtering, for example.

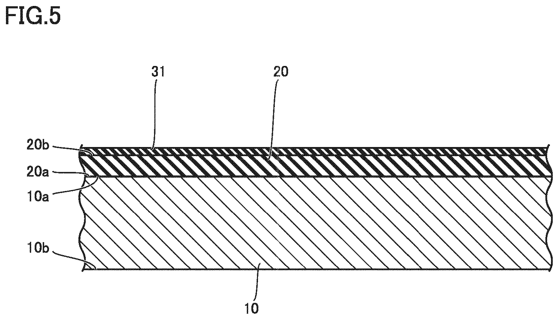

The superconductive layer 30 is formed by performing the solution application step S3, the first calcination step S4 and the second calcination step S5, in other words, by the MOD (Metal Organic Decomposition) method. Fig. 5 is a cross-sectional view illustrating the solution application step S3. As illustrated in Fig. 5, in the solution application step S3, a coating film 31 is formed on the buffer layer 20. The coating film 31 is formed by applying a solution onto the buffer layer 20 and drying the applied solution.

The solution contains a solvent and constituent elements of the superconductive layer 30 solved in the solvent. The solution contains halogen and alkali metal. More specifically, the solution contains alcohol as the solvent, hydrochloric acid as the halogen source, sodium as the alkali metal, and rare earth elements, barium and copper as the constituent elements of the superconductive layer 30. The concentration of the alkali metal in the solution may be 1 ppb or more by mass. As an example, the halogen and the alkali metal may be contained in the solution by adding the halogen and the alkali metal to the solution.

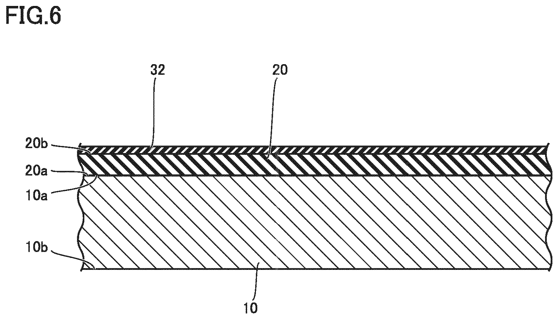

As illustrated in Fig. 6, in the first calcination step S4, the coating film 31 is heated to form a calcined film 32. The calcined film 32 is formed by a precursor of the superconductive layer 30. The precursor of the superconductive layer 30 may formed by a drying treatment for removing an organic solvent, a heat treatment for forming REBa₂Cu₃Oₓ nanocrystals, and another heat treatment for promoting decomposition of the raw material. The heating in the first calcination step S4 is performed in an atmosphere containing oxygen.

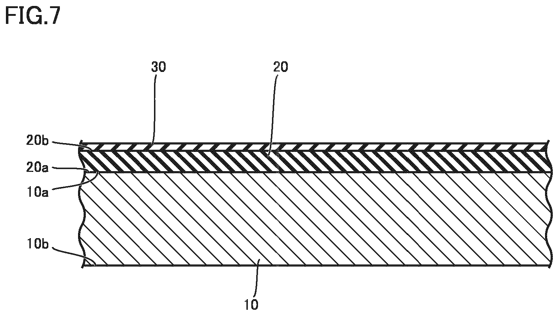

As illustrated in Fig. 7, in the second calcination step S5, the calcined film 32 is heated to form the superconductive layer 30. The heating in the second calcination step S5 is performed in an atmosphere containing oxygen and at a temperature higher than that in the first calcination step S4.

When the heating in the second calcination step S5 is performed, the REBa₂Cu₃Oₓ crystals are epitaxially grown and oriented so that the c-axis thereof is along the normal direction of the main surface 20b. While the heating in the second calcination step S5 is performed, there is a region where the epitaxial growth of REBa₂Cu₃Oₓ is unlikely to occur, and Ba₂Cu₃O₄X₂ precipitates in this region. Since the epitaxial growth of REBa₂Cu₃Oₓ is likely to occur around the precipitated Ba₂Cu₃O₄X₂, the orientation of REBa₂Cu₃Oₓ crystals is promoted by halogen contained in the solution.

By sequentially repeating the solution application step S3, the first calcination step S4, and the second calcination step S5, the film thickness of the superconductive layer 30 becomes thicker, and thereby the superconductive wire 100 having the structure illustrated in Fig. 1 is obtained. Since halogen is unevenly distributed in the main surface 30b of the superconductive layer 30 and the vicinity thereof as the solution application step S3, the first calcination step S4 and the second calcination step S5 are sequentially repeated, and as a result, when the superconductive layer 30 is formed by the MOD method using a solution containing halogen, the amount of Ba₂Cu₃O₄X₂ precipitated on the main surface 30b is larger than the amount of Ba₂Cu₃O₄X₂ precipitated in the superconductive layer 30.

### <Modification>

In the above example, the solution containing the alkali metal is used, but the alkali metal may be contained in the atmosphere where the second calcination step S5 is performed instead of being contained in the solution. In this case, the partial pressure of the alkali metal in the atmosphere may be 1000 Pa or more. The gas constituting the atmosphere where the second calcination step S5 is performed may contain, for example, oxygen, an inert gas, and an alkali metal. The inert gas is, for example, argon or nitrogen. The pressure of the atmosphere is, for example, atmospheric pressure (101.3 kPa). The alkali metal may be contained in the calcined film 32. As an example, the alkali metal may be contained in the atmosphere or the calcined film 32 by adding the alkali metal to the atmosphere or the calcined film 32.

As described above, since the alkali metal is contained in the solution used in the solution application step S3, the alkali metal is also contained in the calcined film 32. During the heating in the second calcination step S5, the alkali metal in the calcined film 32 is vaporized. The vaporized alkali metal reacts with chlorine in the superconductive layer 30, and is discharged to the outside. Therefore, in the superconductive wire 100, the concentration of halogen in the superconductive layer 30 is reduced to less than 2000 ppm by mass as compared with the case where no alkali metal is contained in the solution. The concentration of halogen in the superconductive layer 30 can be reduced to, for example, 1800 ppm or less by mass, or 1500 ppm or less by mass.

In the superconductive wire 100, since the concentration of halogen in the superconductive layer 30 is reduced, it is possible to prevent the compositional balance of REBa₂Cu₃Oₓ constituting the superconductive layer 30 from being disrupted and prevent the volume of the superconductive layer 30 from being reduced.

In the superconductive wire 100, since the alkali metal is contained in the solution used in the solution application step S3, the alkali metal may remain in the superconductive layer 30; but even if the alkali metal remains in the superconductive layer 30, the alkali metal is unlikely to adversely affect the superconductive characteristics of the superconductive layer 30. The concentration of halogen in the superconductive layer 30 can be similarly reduced not only in the case when the alkali metal is contained in the solution used in the solution application step S3 but also in the case when the alkali metal is contained in the calcined film 32 or the atmosphere in the second calcination step S5.

It should be understood that the embodiments disclosed herein have been presented for the purpose of illustration and description but not limited in all aspects. It is intended that the scope of the present invention is not limited to the description above but defined by the scope of the claims.

### REFERENCE SIGNS LIST

10: substrate; 10a, 10b: main surface; 20: buffer layer; 20a, 20b: main surface; 30: superconductive layer; 30a, 30b: main surface; 31: coating film; 32: calcined film; 100: superconductive wire; S1: preparation step; S2: buffer layer formation step; S3: solution application step; S4: first calcination step; S5: second calcination step.

## Claims

1. A superconductive wire (100) comprising:
a superconductive layer (30) containing REBa₂Cu₃Oₓ,
wherein RE represents a rare earth element,
the superconductive layer (30) contains halogen and an alkali metal, and **characterised in that**
the concentration of the halogen in the superconductive layer (30) is less than 2000 ppm by mass.

2. The superconductive wire (100) according to claim 1, wherein the concentration of the halogen in the superconductive layer (30) is 2 ppm or more by mass.

3. The superconductive wire (100) according to claim 1 or claim 2, wherein the halogen is chlorine.

4. The superconductive wire (100) according to any one of claims 1 to 3, wherein the concentration of the alkali metal in the superconductive layer is 1 ppb or more by mass.

5. The superconductive wire (100) according to claim 4, wherein the alkali metal is sodium.

6. The superconductive wire (100) according to any one of claims 1 to 5, further comprising:
a substrate (10); and
a buffer layer (20) disposed on the substrate (10),
wherein the superconductive layer (30) has a first main surface (30a) and a second main surface (30b) opposite to the first main surface (30a),
the superconductive layer (30) is disposed on the buffer layer (20) in such a manner that the first main surface (30a) faces the buffer layer (20),
an amount of Ba₂Cu₃O₄X₂ precipitated on the second main surface (30b) is greater than an amount of Ba₂Cu₃O₄X₂ precipitated in the superconductive layer (30), and
X represents halogen.

7. A method of manufacturing a superconductive wire (100), comprising:
a step of forming a superconductive layer (30) composed of REBa₂Cu₃Oₓ on a buffer layer (20) disposed on a substrate (10),
wherein RE represents a rare earth element,
forming the superconductive layer (30) includes applying a solution containing a constituent element of the superconductive layer (30) onto the buffer layer (20), forming a precursor of the superconductive layer by heating the applied solution, and forming the precursor into the superconductive layer (30) by heating the precursor,
the solution contains halogen, and
at least one of the solution, the precursor and an atmosphere in which the precursor is heated contains an alkali metal.

8. The method of manufacturing a superconductive wire (100) according to claim 7, wherein the concentration of the alkali metal in the solution is 1 ppb or more by mass.

9. The method of manufacturing a superconductive wire (100) according to claim 7 or 8, wherein the partial pressure of the alkali metal in the atmosphere is 1000 Pa or less.

10. The method of manufacturing a superconductive wire (100) according to any one of claims 7 to 9, wherein the halogen is chlorine.

11. The method of manufacturing a superconductive wire (100) according to any one of claims 7 to 10, wherein the alkali metal is sodium.

## Patentansprüche

1. Supraleitender Draht (100), der umfasst:
eine supraleitende Schicht (30), die REBa₂Cu₃Oₓ enthält,
wobei RE ein Seltenerdelement repräsentiert,
die supraleitende Schicht (30) Halogen sowie ein Alkalimetall enthält, und
**dadurch gekennzeichnet, dass**
die Konzentration des Halogens in der supraleitenden Schicht (30) weniger als 2000 ppm nach Masse beträgt.

2. Supraleitender Draht (100) nach Anspruch 1, wobei die Konzentration des Halogens in der supraleitenden Schicht (30) 2 ppm nach Masse oder mehr beträgt.

3. Supraleitender Draht (100) nach Anspruch 1 oder Anspruch 2, wobei das Halogen Chlor ist.

4. Supraleitender Draht (100) nach einem der Ansprüche 1 bis 3, wobei die Konzentration des Alkalimetalls in der supraleitenden Schicht 1 ppb nach Masse oder mehr beträgt.

5. Supraleitender Draht (100) nach Anspruch 4, wobei das Alkalimetall Natrium ist.

6. Supraleitender Draht (100) nach einem der Ansprüche 1 bis 5, der des Weiteren umfasst:
ein Substrat (10); sowie
eine Pufferschicht (20), die auf dem Substrat (10) angeordnet ist,
wobei die supraleitende Schicht (30) eine erste Hauptfläche (30a) sowie eine zweite Hauptfläche (30b) aufweist, die der ersten Hauptfläche (30a) gegenüberliegt,
die supraleitende Schicht (30) auf der Pufferschicht (20) so angeordnet ist, dass die erste Hauptfläche (30a) der Pufferschicht (20) zugewandt ist,
eine Menge an Ba₂Cu₃O₄X₂, ausgefällt auf der zweiten Hauptfläche (30b), größer ist als eine Menge an Ba₂Cu₃O₄X₂, ausgefällt auf der supraleitenden Schicht (30), und
X Halogen repräsentiert.

7. Verfahren zum Herstellen eines supraleitenden Drahtes (100), das umfasst:
einen Schritt zum Ausbilden einer aus REBa₂Cu₃Oₓ bestehenden supraleitenden Schicht (30) auf einer Pufferschicht (20), die auf einem Substrat (10) angeordnet ist,
wobei RE ein Seltenerdelement repräsentiert,
wobei Ausbilden der supraleitenden Schicht (30) Aufbringen einer Lösung, die einen Bestandteil der supraleitenden Schicht (30) enthält, auf die Pufferschicht (20), Ausbilden eines Vorläufers auf der supraleitenden Schicht (30) durch Erhitzen der aufgebrachten Lösung sowie Umwandeln des Vorläufers in die supraleitende Schicht (30) durch Erhitzen des Vorläufers einschließt,
wobei die Lösung Halogen enthält, und
die Lösung, der Vorläufer oder/und die Atmosphäre, in der der Vorläufer erhitzt wird, ein Alkalimetall enthält/enthalten.

8. Verfahren zum Herstellen eines supraleitenden Drahtes (100) nach Anspruch 7, wobei die Konzentration des Alkalimetalls in der Lösung 1 ppb nach Masse oder mehr beträgt.

9. Verfahren zum Herstellen eines supraleitenden Drahtes (100) nach Anspruch 7 oder 8, wobei der Teildruck des Alkalimetalls in der Atmosphäre 1.000 Pa oder weniger beträgt.

10. Verfahren zum Herstellen eines supraleitenden Drahtes (100) nach einem der Ansprüche 7 bis 9, wobei das Halogen Chlor ist.

11. Verfahren zum Herstellen eines supraleitenden Drahtes (100) nach einem der Ansprüche 7 bis 10, wobei das Alkalimetall Natrium ist.

## Revendications

1. Fil supraconducteur (100) comprenant :
une couche supraconductrice (30) contenant REBa₂Cu₃O_{X},
où RE représente un élément des terres rares,
la couche supraconductrice (30) contient un halogène et un métal alcalin, et **caractérisé en ce que**
la concentration de l'halogène dans la couche supraconductrice (30) est inférieure à 2000 ppm en masse.

2. Fil supraconducteur (100) selon la revendication 1, dans lequel la concentration de l'halogène dans la couche supraconductrice (30) est supérieure ou égale à 2 ppm en masse.

3. Fil supraconducteur (100) selon la revendication 1 ou la revendication 2, dans lequel l'halogène est le chlore.

4. Fil supraconducteur (100) selon l'une quelconque des revendications 1 à 3, dans lequel la concentration en métal alcalin dans la couche supraconductrice est supérieure ou égale à 1 ppb en masse.

5. Fil supraconducteur (100) selon la revendication 4, dans lequel le métal alcalin est le sodium.

6. Fil supraconducteur (100) selon l'une quelconque des revendications 1 à 5, comprenant en outre :
un substrat (10) ; et
une couche tampon (20) disposée sur le substrat (10),
dans lequel la couche supraconductrice (30) présente une première surface principale (30a) et une seconde surface principale (30b) opposée à la première surface principale (30a),
la couche supraconductrice (30) est disposée sur la couche tampon (20) de manière à ce que la première surface principale (30a) soit tournée vers la couche tampon (20),
une quantité de Ba₂Cu₃O₄X₂ précipitée sur la seconde surface principale (30b) est supérieure à une quantité de Ba₂Cu₃O₄X₂ précipitée dans la couche supraconductrice (30), et
X représente un halogène.

7. Procédé de fabrication d'un fil supraconducteur (100), comprenant :
une étape consistant à former une couche supraconductrice (30) composée de REBa₂Cu₃Oₓ sur une couche tampon (20) disposée sur un substrat (10),
dans lequel RE représente un élément des terres rares,
la formation de la couche supraconductrice (30) comprend l'application d'une solution contenant un élément constitutif de la couche supraconductrice (30) sur la couche tampon (20), la formation d'un précurseur de la couche supraconductrice (30) par chauffage de la solution appliquée, et la formation du précurseur pour obtenir la couche supraconductrice (30) par chauffage du précurseur,
la solution contient un halogène, et
au moins l'un parmi la solution, le précurseur et l'atmosphère dans laquelle le précurseur est chauffé contient un métal alcalin.

8. Procédé de fabrication d'un fil supraconducteur (100) selon la revendication 7, dans lequel la concentration du métal alcalin dans la solution est supérieure ou égale à 1 ppb en masse.

9. Procédé de fabrication d'un fil supraconducteur (100) selon la revendication 7 ou 8, dans lequel la pression partielle du métal alcalin dans l'atmosphère est inférieure ou égale à 1000 Pa.

10. Procédé de fabrication d'un fil supraconducteur (100) selon l'une quelconque des revendications 7 à 9, dans lequel l'halogène est le chlore.

11. Procédé de fabrication d'un fil supraconducteur (100) selon l'une quelconque des revendications 7 à 10, dans lequel le métal alcalin est le sodium.
